(19) Europäisches Patentamt / European Patent Office / Office européen des brevets

(11) **EP 4 765 633 A1**

(12) **EUROPEAN PATENT APPLICATION**

(43) Date of publication:
24.06.2026   Bulletin 2026/26

(21) Application number: 25221456.4

(22) Date of filing: **08.12.2025**

(51) International Patent Classification (IPC):
*H03G 3/30* (2006.01)    *H03G 7/00* (2006.01)

(52) Cooperative Patent Classification (CPC):
**H03G 7/002; H03G 3/3005; H03G 7/007**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority:   20.12.2024   CN 202411895691

(71) Applicant: **Harman International Industries, Incorporated**
**Stamford, Connecticut 06901 (US)**

(72) Inventor: **LIU, Jiahe**
**Stamford, CT, 06901 (US)**

(74) Representative: **Westphal, Mussgnug  & Partner, Patentanwälte mbB**
**Werinherstraße 79**
**81541 München (DE)**

(54)   **AUDIO PEAK LIMITING SYSTEM AND METHOD**

(57)    Provided are an audio peak limiting system and method, which, by setting a moving maximum window to drive gain calculation, and in combination with matching a moving maximum window length to a delay duration of an audio input signal, suppress a risk of overshoot while enabling a user to flexibly adjust a suitable attack time, and result in a smoother gain curve and reduce distortion in dynamic range processing, thereby achieving a more natural auditory perception.

EP 4 765 633 A1

## Description

### Technical Field

The present disclosure generally relates to audio limiting gain processing, and in particular, to a system and method for controlling audio peak limiting by driving gain calculation using a moving maximum window.

### Background

The dynamic range of an audio system is limited, as each component in the system is constrained by the maximum amplitude of the audio signal. The audio system will be unable to process signals that exceed the amplitude limit. For example, an analog-to-digital converter (ADC) will reach saturation when the signal exceeds a certain input voltage. Furthermore, in analog signals, the clipping voltage of amplifiers and the displacement limit of the loudspeaker diaphragms must be taken into consideration. Otherwise, distortion will be introduced into the audio signal, potentially even leading to device damage. A common remedial measure for this is to employ an audio peak limiter to reduce the dynamic range of the audio input signal.

A limiter, also referred to as a dynamic range controller (DRC), can control the peak of the output signal below a threshold. However, audio peak limiters widely used today require a very short attack time while keeping the audio output signal below the magnitude threshold, which is often undesirable for human auditory perception. In some scenarios requiring an extremely short attack time (e.g., less than 0.1 ms), the initiation of the limiter itself may introduce new distortions. If the user is allowed to select a longer attack time (e.g., greater than 5 ms), the time delay required to wait for the limiter to start functioning may cause the audio output signal to exceed the magnitude threshold, thereby leading to distortion in the audio playback system.

Consequently, it is difficult for current audio systems to suppress overshoot while allowing for adjustment to a suitable attack time. Therefore, an improved audio peak limiting system and method are needed to enable solving this problem in the prior art.

### Summary of the Invention

In order to enable a user to flexibly set an appropriate attack time for an audio peak limiter while simultaneously preventing the presence of overshoot in the audio output signal, the present disclosure provides an audio peak limiting method and system. By using a moving maximum window to drive audio gain calculation, and in combination with matching the audio delay time to a moving maximum window length, the system can be enabled to have a suitable attack time without the risk of overshoot occurring. Through such an approach, the gain curve of this audio peak limiting system is very smooth, resulting in more natural sounding audio playback, and reduced distortion caused by dynamic range processing.

According to one aspect of the present disclosure, an audio peak limiting system is provided. This audio peak limiting system includes a time delay module, a moving maximum module, a static-gain calculation module, a gain smoothing module, and a gain application module. The time delay module is configured to delay an audio input signal in time by a delay duration to obtain a delayed audio input signal. The moving maximum module is configured to determine a moving maximum magnitude level of the audio input signal, where the moving maximum magnitude level is a maximum value of a magnitude level of the audio input signal within a moving maximum window, where a length of the moving maximum window matches the set delay duration. The static-gain calculation module is configured to calculate and output instantaneous gain. The gain smoothing module is configured to smooth the instantaneous gain into smoothed gain, and the gain application module is configured to apply the smoothed gain to the delayed audio input signal to generate an audio output signal.

According to another aspect of the present disclosure, an audio peak limiting method is provided. The steps of the audio peak limiting method include: delaying, in a main path via a time delay module, an audio input signal in time by a delay duration to obtain a delayed audio input signal. The steps of the audio peak limiting method further include: determining, in a side path via a moving maximum module, a moving maximum magnitude level of the audio input signal, where the moving maximum magnitude level is a maximum value of a magnitude level of the audio input signal within a moving maximum window, where a length of the moving maximum window matches the set delay duration; then, calculating and outputting, via a static-gain calculation module, instantaneous gain; and subsequently smoothing, via a gain smoothing module, the instantaneous gain into smoothed gain. Finally, the steps of the audio peak limiting method further include: applying, via a gain application module, the smoothed gain to the delayed audio input signal to generate an audio output signal.

Furthermore, yet another aspect of the present disclosure further provides a non-transitory computer-readable medium having instructions stored thereon, where the instructions, when executed by one or more processors, cause the one or more processors to perform the aforementioned audio peak limiting method.

## Brief Description of the Drawings

These and/or other features, aspects and advantages of the present invention will be better understood upon reading the following detailed description with reference to the accompanying drawings, where the same characters represent the same parts throughout these accompanying drawings, in which:

FIG. 1A exemplarily illustrates a curve of an amplitude of an audio input signal and a curve of an amplitude of an audio output signal of an audio peak limiter; correspondingly, FIG. 1B exemplarily illustrates a curve of gain applied in the example of FIG. 1A;
FIG. 2 exemplarily illustrates a structural schematic diagram of an audio peak limiting system according to one or more embodiments of the present disclosure;
FIG. 3 exemplarily illustrates an algorithmic schematic diagram of a moving maximum module of an audio peak limiting system according to one or more embodiments of the present disclosure;
FIG. 4 exemplarily illustrates an instantaneous-gain mapping curve of a static-gain calculation module in an audio peak limiting system according to one or more embodiments of the present disclosure;
FIG. 5 exemplarily illustrates a schematic flowchart of an audio peak limiting method according to one or more embodiments of the present disclosure;
FIG. 6 exemplarily illustrates another structural schematic diagram of an audio peak limiting system according to one or more embodiments of the present disclosure; and
FIGS. 7A to 7C exemplarily illustrate comparative schematic diagrams before and after limiting is performed on an audio input signal in accordance with an audio peak limiting system and method according to one or more embodiments of the present disclosure.

## Detailed Description

The description of various embodiments is given below for illustrative purposes, but is not intended to be exhaustive or limit the disclosed embodiments. Many modifications and variations will be apparent to those of ordinary skill in the art without departing from the scope and spirit of the described embodiments.

An audio peak limiting system essentially applies time-varying gain to an audio input signal, thereby reducing excessively high amplitude peaks in the audio input signal while leaving the other parts unchanged. The audio output signal resulting from limiting may, for example, then be fed into a power amplifier, or subsequently can safely drive a loudspeaker to perform playback of the audio input signal.

Therefore, in an audio peak limiting system, once the audio input signal has an excessively high amplitude, the limiting system applies gain attenuation to reduce the excessively high amplitude peaks in the audio input signal. However, in practical operations, the audio output signal resulting from limiting sometimes still exceeds the amplitude limit of the audio limiter, resulting in overshoot and causing distortion of sound.

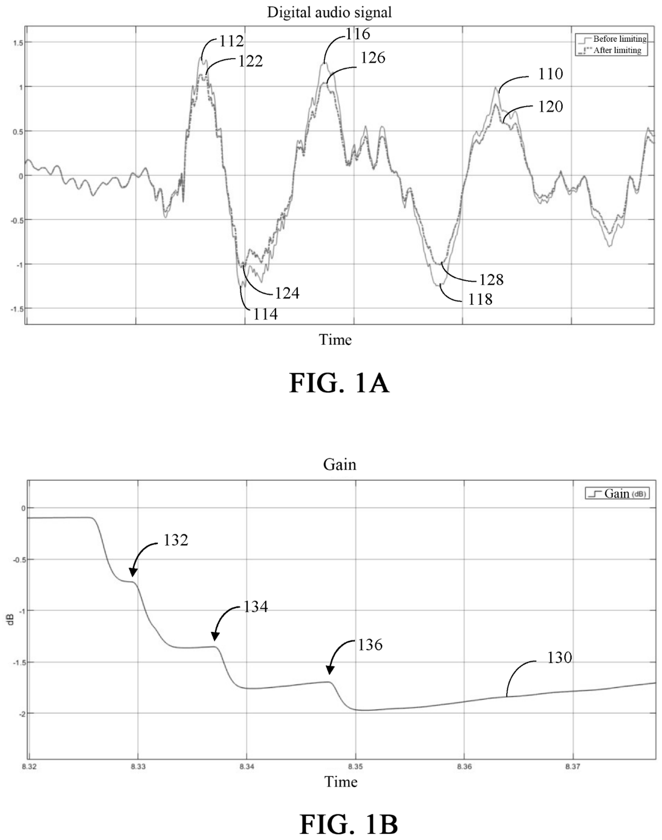

FIG. 1A exemplarily illustrates a curve 110 of an amplitude of an audio input signal and a curve 120 of an amplitude of an audio output signal of an audio peak limiter. In the example shown in FIG. 1A, the curve 110 of the amplitude of the audio input signal before limiting is performed is shown by a solid line; whereas the curve 120 of the amplitude of the audio output signal after limiting is performed is performed is shown by a dashed line. In this example, the magnitude level threshold of the audio peak limiter has been set to 1, and both the curves 110 and 120 have been delayed in time by a delay duration of 10 ms. It can be seen from FIG. 1A that, for example, the curve 110 of the amplitude of the audio input signal exceeds 1 at each of 112, 114, 116, and 118. However, although subjected to limiting by the audio peak limiter, while the amplitude of the curve 120 of the amplitude of the audio output signal at point 128 does not exceed the magnitude level threshold, the amplitudes at corresponding points 122, 124, and 126 resulting from limiting still exceed 1, leading to overshoot.

FIG. 1B exemplarily illustrates a curve 130 of gain applied to the audio input signal in the example of FIG. 1A. In the example shown in FIG. 1B, the attack time of the audio peak limiter has been set to, for example, 5 ms, which is a medium attack time, and compared with FIG. 1A, the gain curve 130 in FIG. 1B does not include the delay duration. It can be seen from FIG. 1B that the gain curve 130 exhibits step changes at 132, 134, and 136 thereof, which are caused by the limited attack time of the audio peak limiter. Thus, it can be seen that although gain attenuation can reduce the instantaneous gain during a specific time window, in scenarios requiring a very short attack time, the time for the gain to reduce to the required gain attenuation is limited. Consequently, the gain cannot smoothly and sufficiently decrease during the specific time window of the audio peak limiter, causing the amplitude of the audio output signal to still have overshoot, which introduces distortion into the user's auditory perception of the audio output signal.

Unpleasant distortion in the audio output signal is often related to parameter settings of the audio peak limiter.

Therefore, being capable of appropriately setting the delay duration and the attack time for the audio input signal is crucial for the performance of the audio peak limiter.

One aspect of the present disclosure provides an audio peak limiting system, which, by setting a moving maximum window to drive the calculation of gain for the audio input signal, can enable a user to flexibly adjust the attack time, while simultaneously enabling the gain attenuation to fully decrease, and making the time-varying gain smoother, thereby eliminating overshoot in the audio output signal and ensuring that the user can obtain an authentic and natural auditory effect.

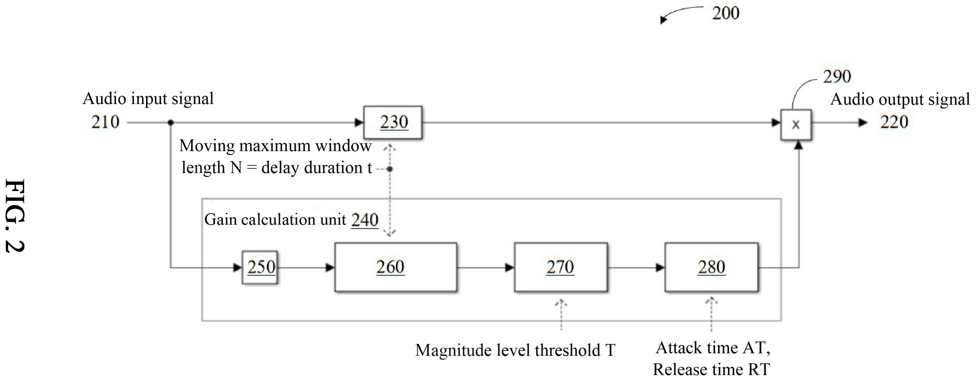

FIG. 2 exemplarily illustrates a structural schematic diagram 200 of an audio peak limiting system according to one or more embodiments of the present disclosure. This is a feed-forward audio peak limiter capable of delaying an audio input signal 210 in time and calculating gain in advance, thereby applying time-varying gain to the delayed audio input signal to obtain an audio output signal 220 resulting from limiting. Therefore, after limiting by the audio peak limiting system provided according to the present disclosure, excessively high amplitude peaks in the audio input signal 210 can be reduced, while amplitudes of the other parts remain unchanged.

As shown in FIG. 2, the audio input signal 210 can separately enter a main path and a side path. In the main path, the audio input signal 210 may be delayed in time by a certain delay duration to wait for the time-varying gain to be calculated in the side path. In the main path, the audio input signal 210 may be delayed in time by a certain delay duration *t* via a time delay module 230. This delay duration *t* may be an adjustable parameter set by a user, thereby enabling waiting for a gain calculation unit 240 in the side path to execute gain calculation first before applying the gain to the delayed audio input signal.

As shown in FIG. 2, for the audio input signal 210 entering the gain calculation unit 240 in the side path, the bipolar amplitude of the audio input signal 210 will first be converted into magnitude levels represented in unipolar form in a polarity conversion module 250. The polarity conversion module 250 may be configured to perform an operation of taking an absolute value of the amplitude of the audio input signal 210. Specifically, in the polarity conversion module 250, the magnitude level of the audio input signal 210 may be determined by acquiring an absolute value of the amplitude of the audio input signal 210. Additionally or alternatively, the polarity conversion module 250 may also be configured to employ, for example, a peak detector to determine the magnitude level of the audio input signal 210.

Next, the determined magnitude level of the audio input signal 210 is passed through a moving maximum module 260 to detect a magnitude level maximum value of the magnitude level of the audio input signal 210 within a moving maximum window. The moving maximum module 260 may be configured to have an adjustable parameter, namely, a moving maximum window length *N*. This moving maximum window length *N* can match the delay duration *t* in the time delay module 230 in the main path of the audio peak limiting system. That is, the moving maximum window length *N* and the delay duration *t* have the same duration. As mentioned previously, the delay duration *t* of the time delay module 230 in the main path is an adjustable parameter that can be set by the user. Therefore, in the side path, the moving maximum window length N in the moving maximum module 260 can be made to match the time delay duration *t* in the main path, that is, the moving maximum window length *N* = the time delay duration *t*.

The moving maximum module 260 may be configured to calculate a maximum value among the magnitude levels of the samples of the audio input signal within a moving maximum window of length N preceding a current sample of the audio input signal, and output this magnitude level maximum value as the magnitude level value of the current sample. For example, for a current n-th sample of the audio input signal, when the moving maximum window length is *N,* a magnitude level maximum value in each sample *i* within the moving maximum window is calculated. Therefore, the moving maximum module 260 may be configured to calculate and output a maximum value among the magnitude levels of the current sample *n* and the previous (*N*-1) samples of the audio input signal as the output magnitude level value of the current sample n. The algorithm in this moving maximum module 260 may be described as follows:

**Acquire** the magnitude level value of the current sample of the audio input signal = x(n);

**Calculate and output** y(n) = max{x(n), x(n-1), …, x(n-N+1)};

**for** each sample i = 1 to N in the moving maximum window,

    x(n-i) = x(n-i+1); /*Shift the moving maximum window backward by 1 sample */

**end for**

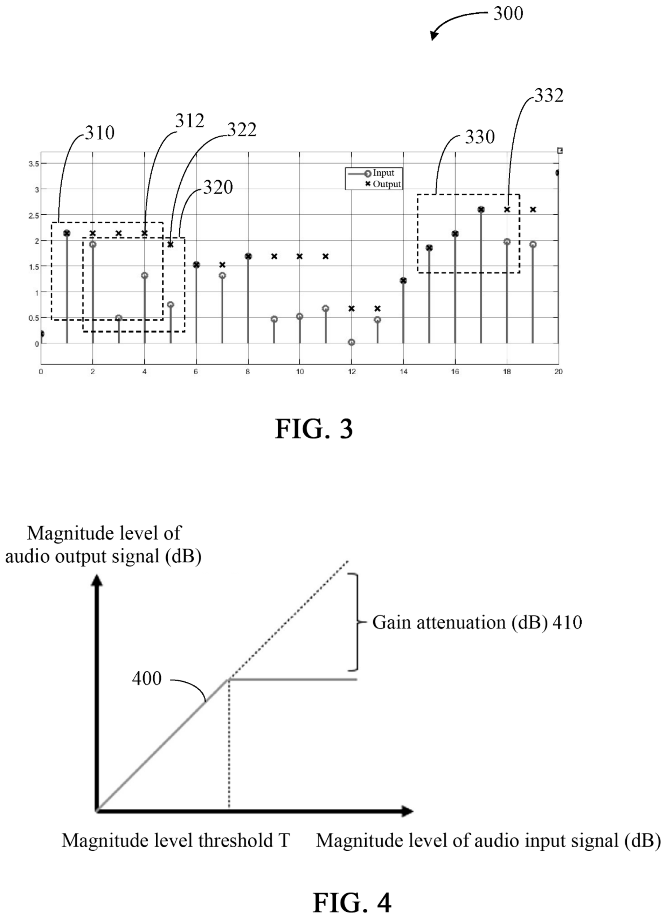

FIG. 3 exemplarily illustrates an algorithmic schematic diagram 300 of a moving maximum module of an audio peak limiting system according to one or more embodiments of the present disclosure. "o" denotes a magnitude level input value of an audio input signal sample that is input to the moving maximum module; and "x" denotes a magnitude level output value of the audio input signal sample that is output from the moving maximum module. In the example shown in FIG. 3, the moving maximum window length set in the moving maximum module is *N* = 4. In combination with the algorithm of the moving maximum module described above, for example, for the current sample n = 4, the magnitude level input value of x(4) is first acquired and recorded, and the moving maximum module has already acquired and recorded the magnitude level input values { x(4), x(3), x(2), x(1)} of N = 4 samples in the moving maximum window 310 preceding the current sample. As can be seen from FIG. 3, within the moving maximum window 310, the magnitude level input value of x(1) is the largest. Therefore, for the current sample n = 4, the magnitude level output value 312 of x(4) should be output as equal to the magnitude level input value of x(1), which is the largest magnitude level input value in this moving maximum window 310, that is, the moving maximum module outputs the magnitude level output value of x(4), which is equal to the magnitude level input value of x(1). Then, the moving maximum module shifts the moving maximum window backward by 1 sample through a for loop, and repeats the aforementioned algorithm of the moving maximum module for the next sample n = 5.

Therefore, for the next sample $n = 5$, the magnitude level input value of x(5) is first acquired and recorded, and for the sample $n = 5$, the moving maximum module outputs the magnitude level output value 322 of x(5) as the magnitude level input value of x(2), which is the largest magnitude level input value in the moving maximum window 320, that is, the magnitude level output value of x(5) equals the magnitude level input value of x(2), and so on. Similarly, referring to FIG. 3, it can also be obtained that, for example, from the moving maximum window 330, for $n = 18$, the moving maximum module will output the magnitude level output value 332 of x(18) as equal to the magnitude level input value of x(17), and this process continues. It should be noted that the moving maximum window length N = 4 samples in the aforementioned example is for illustrative purposes only. In practical applications, the moving maximum window length $N$ can match the delay duration $t$ set by the user and can be adjusted accordingly. For example, the moving maximum window length N may enable the moving maximum window to include, for instance, several hundred samples of the magnitude level of the audio input signal.

As mentioned previously, when the audio input signal has an excessively high amplitude peak, the audio peak limiting system should calculate and apply gain attenuation to reduce the excessively high amplitude peak in the audio input signal. After the maximum value of the magnitude level input values of the audio input signal within the moving maximum window is calculated in the moving maximum module and this maximum value is output as the magnitude level output value, this magnitude level output value serves as the moving maximum magnitude level of the audio input signal, and gain may be calculated for the moving maximum magnitude level of the audio input signal by the static-gain calculation module 270 shown in FIG. 2. The static-gain calculation module 270 may be configured in the form of a nonlinear function, which can map gain according to the moving maximum magnitude level of the audio input signal input thereto. A magnitude level threshold T may be configured in the static-gain calculation module 270. This magnitude level threshold T may be configured for the magnitude level of the audio input signal by the user as needed. Once the moving maximum magnitude level of the audio input signal exceeds this magnitude level threshold T, limiting should be performed on it. Gain attenuation should be applied to the moving maximum magnitude level of the audio input signal that exceeds this magnitude level threshold T, such that the magnitude level of the audio output signal subsequently output by the audio peak limiting system does not exceed the magnitude level threshold T. Therefore, excessively high amplitude peaks in the audio input signal will be reduced, while the other parts remain unchanged.

The static-gain calculation module 270 may be configured to map and output instantaneous gain according to the relationship from the magnitude level of the audio input signal to the magnitude level of the audio output signal determined as described above. FIG. 4 exemplarily illustrates an instantaneous-gain mapping curve 400 of a static-gain calculation module in an audio peak limiting system according to one or more embodiments of the present disclosure. As can be seen from the instantaneous-gain mapping curve 400 of the static-gain calculation module, when the magnitude level of the audio input signal does not exceed the magnitude level threshold T, the magnitude level of the audio output signal is the same as the magnitude level of the audio input signal, i.e., the static-gain calculation module outputs instantaneous gain of 1 (gain attenuation of 0 dB) when the magnitude level of the audio input signal does not exceed the magnitude level threshold T; in contrast, when the magnitude level of the audio input signal exceeds the magnitude level threshold T, it is necessary to apply gain attenuation 410 to the magnitude level of the audio input signal to perform limiting on the magnitude level of the audio output signal to make it not exceed the magnitude level threshold T, that is, the static-gain calculation module outputs the gain attenuation 410 (in units of dB) when the magnitude level of the audio input signal exceeds the magnitude level threshold T. Applying gain attenuation to the magnitude level of the audio input signal that exceeds the magnitude level threshold T can ensure that the magnitude level of the audio output signal of the audio peak limiting system is limited to not exceed the magnitude level threshold T.

Through such an approach, it should be noted that the gain mapped and output by the static-gain calculation module 270 is instantaneous gain/instantaneous-gain attenuation having a transient nature. Referring back to FIG. 2, in one or more embodiments of the present disclosure, the static-gain calculation module 270 may be configured as follows:

(1) when the moving maximum magnitude level of the audio input signal does not exceed the magnitude level threshold T, the static-gain calculation module 270 outputs instantaneous gain of 1; and
(2) when the moving maximum magnitude level of the audio input signal exceeds the magnitude level threshold $T$, the static-gain calculation module 270 outputs instantaneous-gain attenuation in units of dB.

Transient instantaneous gain may possibility introduce unwanted noise into the user's auditory perception. Therefore, before applying the instantaneous gain calculated using the static-gain calculation module to the delayed audio input signal, this instantaneous gain needs to undergo smoothing processing. Referring to FIG. 2, a gain smoothing module 280 may be configured in the form of a low-pass filter, which may be configured with different coefficients. These coefficients may be related to, for example, an attack time *AT* and a release time *RT,* both of which are variable parameters adjustable by the user.

In one or more embodiments, the gain smoothing module 280 may be configured to have characteristics of the following low-pass filter:

$$g_s(n) = \begin{cases} \alpha_A g_s(n-1) + (1-\alpha_A)g_i(n), if \ g_i(n) \leq g_s(n-1) \\ \alpha_R g_s(n-1) + (1-\alpha_R)g_i(n), if \ g_i(n) > g_s(n-1) \end{cases} \tag{1}$$

where, $g_s$ is the smoothed gain resulting from smoothing processing;
$g_i$ is the instantaneous gain (or instantaneous-gain attenuation);
n indicates the current sample of the audio input signal; and
$\alpha_A$ and $\alpha_R$ are coefficients related to the attack time *AT* and the release time RT, respectively.

The attack time *AT* is defined as the time required for the low-pass filter defined by the above Equation (1) to transition from 10% to 90% of its final value under a step input, where the coefficient related to the attack time *AT* may be given by the following equation:

$$\alpha_A = 9^{\frac{-1}{F_s T_A}} \tag{2}$$

where, *Fs* is the sampling rate; and
$T_A$ is the attack time AT.

Finally, as shown in FIG. 2, the smoothed gain resulting from smoothing processing by the gain smoothing module 280 may be applied in the gain application module 290 to the delayed audio input signal that is input from the main path. For example, in the gain application module 290, the delayed audio input signal may be multiplied by the smoothed gain, thereby generating the audio output signal 220.

As mentioned previously, the moving maximum window length N set in the moving maximum module 260 determines the time before the peak of the audio input signal arrives when the gain attenuation begins to decrease. In contrast, the attack time *AT* set in the gain smoothing module 280 determines the slope of the gain attenuation. If the attack time *AT* is less than the moving maximum window duration *N,* overshoot will not occur in the audio output signal 220. This provides the user with great freedom and flexibility in adjusting the attack time *AT.* The user may choose to configure a medium to long attack time *AT* without worrying about overshoot causing voltage clipping and thereby introducing noise. This also avoids the necessity for the user to select a more conservative magnitude level threshold *T* in order to configure a not-too-short attack time *AT.* Furthermore, the dynamic range of this audio peak limiting system can be fully utilized for the maximum loudness of the audio signal.

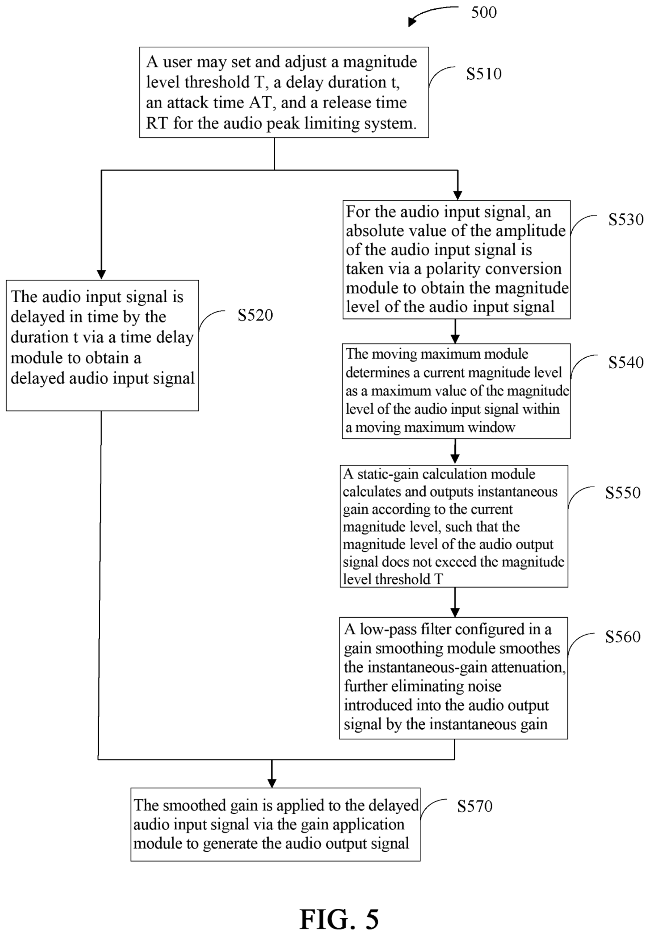

FIG. 5 exemplarily illustrates a schematic flowchart 500 of an audio peak limiting method according to one or more embodiments of the present disclosure. As shown in FIG. 5, first, in step S510, the user may adjust variable parameters of the audio peak limiting system. For example, the user may adjust variable parameters in the system according to the current audio device's performance and/or the audio input signal. For instance, the user may set the magnitude level threshold *T* of the audio input signal, and the user may also adjust the delay duration *t* in time of the delayed audio input signal and the attack time *AT* and the release time *RT* of the gain attenuation for the purpose of applying gain attenuation.

The audio input signal then simultaneously enters the main path and the side path of the audio peak limiting system. The audio input signal will be delayed by a certain delay duration t in the main path of the audio peak limiting system, and the audio input signal will undergo gain calculation in the side path of the audio peak limiting system.

On one hand, in the main path, in step S520, the audio input signal is delayed in time by the duration t via a time delay module, thereby obtaining a delayed audio input signal.

On the other hand, in the side path, in step S530, for the audio input signal, an absolute value of the amplitude of the audio input signal may be taken via a polarity conversion module to obtain the magnitude level of the audio input signal. Then, in step S540, the moving maximum magnitude level of the audio input signal within a moving maximum window is determined via a moving maximum module. The length N of the moving maximum window matches the delay duration *t* configured in the time delay module in the main path, i.e., *N* = *t*, and the moving maximum magnitude level of the audio input signal is the maximum value among the magnitude levels of the samples of the audio input signal within the moving maximum window.

After determining the moving maximum magnitude level in the moving maximum window, in step S550, instantaneous gain is calculated and output via a static-gain calculation module according to the moving maximum magnitude level. For this instantaneous gain, (1) instantaneous gain $g_i = 1$ may be output when the moving maximum magnitude level of the audio input signal does not exceed the magnitude level threshold T, such that the magnitude level of the audio output signal is maintained at the magnitude level of the audio input signal; and (2) instantaneous-gain attenuation (in units of dB) may be output when the moving maximum magnitude level of the audio input signal exceeds the magnitude level threshold T, so as to perform limiting on the audio input signal, such that the magnitude level of the audio output signal does not exceed the magnitude level threshold T.

Next, in step S560, the instantaneous gain is smoothed via a low-pass filter configured in a gain smoothing module to output smoothed gain. The configuration of the coefficients of the low-pass filter in the gain smoothing module is related to the configuration of the attack time *AT* and the release time *RT*. The gain smoothing processing in the gain smoothing module further eliminates noise introduced into the audio output signal by the transient nature of the instantaneous gain and the instantaneous-gain attenuation.

Finally, as shown in FIG. 5, in step S570, the smoothed gain is applied to the delayed audio input signal via a gain application module, for example, by multiplying the smoothed gain with the delayed audio input signal, thereby generating an audio output signal.

The audio peak limiting system and method according to one or more embodiments of the present disclosure can be used in different scenarios. For example, the audio peak limiting system described above may be arranged in an audio system as a pre-stage to a power amplifier, for allowing, for instance, a digital audio input signal that has undergone analog-to-digital conversion (ADC) and sampling quantization to enter the audio peak limiting system for limiting, so as to prevent signal input voltage saturation during subsequent power amplification, thereby avoiding audio distortion caused by voltage clipping of the amplifier.

Additionally or alternatively, such an audio peak limiting system may also be arranged as, for example, a pre-stage to a loudspeaker device, for limiting the amplitude of the audio playback signal such that it does not exceed the maximum peak displacement limit of the loudspeaker diaphragm. A loudspeaker can exhibit different performance differences when the amplitude (or magnitude) of the audio input signal is large. The maximum peak displacement limit of the loudspeaker diaphragm is an important parameter of loudspeaker performance, and this parameter is usually listed in the loudspeaker specification sheet.

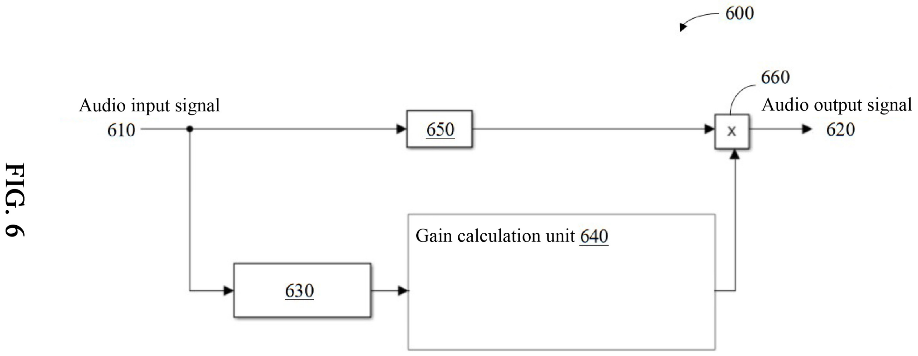

FIG. 6 schematically illustrates another structural schematic diagram 600 of an audio peak limiting system according to one or more embodiments of the present disclosure. The structure of the audio peak limiting system shown in FIG. 6 is similar to the structure shown in FIG. 2, and is also a feed-forward audio peak limiter. The difference between the two lies in that the structure of the audio peak limiting system shown in FIG. 6 additionally includes a loudspeaker displacement model module 630 in the side path. Therefore, before the audio input signal 610 enters the gain calculation unit 640 in the side path for gain calculation, the maximum displacement of the loudspeaker diaphragm that could be caused by the amplitude of the audio input signal 610 may first be estimated via the loudspeaker displacement model module 630.

The loudspeaker displacement model module 630 may be configured to estimate, by referencing a loudspeaker displacement model and based on the amplitude of the audio input signal 610 entering the module, the maximum displacement resulting from the offset of the diaphragm or voice coil of the loudspeaker that would be caused by the audio input signal 610 in the loudspeaker. **In** one or more embodiments, the user may set the magnitude level threshold *T* to represent an upper limit of the maximum peak displacement of the loudspeaker diaphragm, for example, 2 mm. That is to say, the user may set the magnitude level threshold T of the audio peak limiting system in accordance with the maximum peak displacement limit of the loudspeaker diaphragm. Therefore, the audio peak limiting system may be configured to apply gain based on the maximum displacement estimated by the loudspeaker displacement model module 630, so as to protect the displacement of the loudspeaker diaphragm from exceeding this maximum peak displacement limit. Thus, it can be seen that in scenarios requiring consideration of the displacement limit of the loudspeaker diaphragm, this audio peak limiting system may be arranged as a pre-stage to a loudspeaker device to estimate, via the loudspeaker displacement model module 630, the displacement of the loudspeaker diaphragm that would be caused by the amplitude of the audio input signal 610, and calculate and output gain in the gain calculation unit 640, so as to perform limiting on the audio input signal 610, thereby avoiding device damage caused by the displacement of the loudspeaker diaphragm exceeding its maximum peak displacement limit during playback by the loudspeaker of the audio output signal 620 resulting from limiting.

As shown in FIG. 6, the process of gain calculation in the gain calculation unit 640 may be similar to that in the gain calculation unit 240 of the audio peak limiting system shown in FIG. 2, and therefore is not redundantly described here. Finally, the time-varying smoothed gain $g_s$ calculated and output by the gain calculation unit 640 is multiplied in the gain application module 660 with the delayed audio input signal, which is delayed by the time delay module 650 and input from the main path, to obtain the audio output signal 620 resulting from limiting. Therefore, excessively high amplitude peaks in the audio input signal 610 are reduced, such that even when the audio output signal 620 is played back at maximum loudness through the loudspeaker, it will not exceed the maximum displacement limit of the loudspeaker diaphragm.

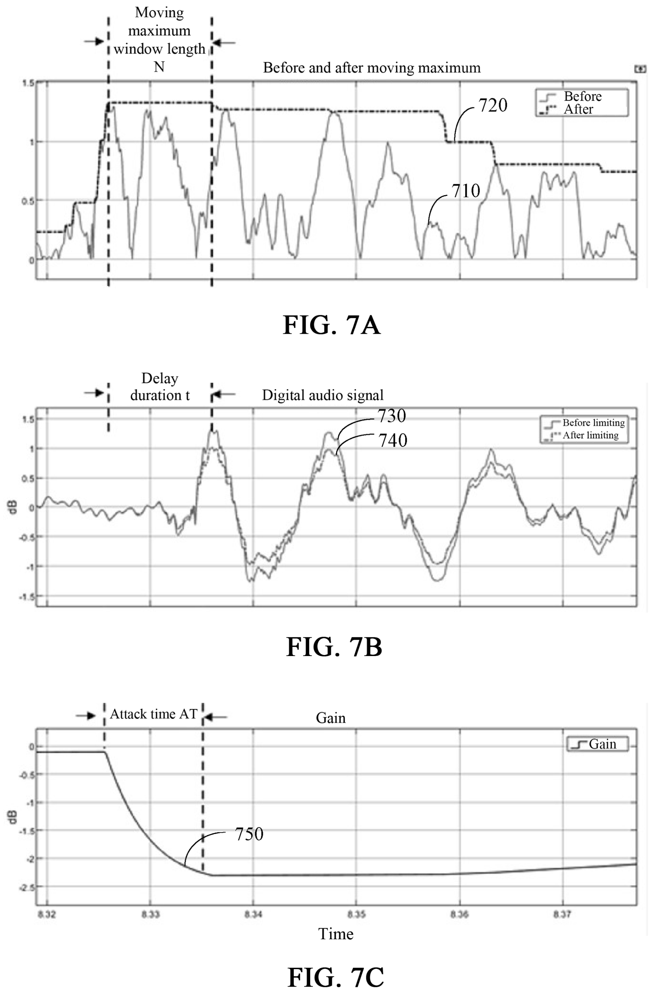

FIGS. 7A to 7C exemplarily illustrate comparative schematic diagrams before and after limiting is performed on an audio input signal in accordance with an audio peak limiting system and method according to one or more embodiments of the present disclosure. In this example, the method for using a moving maximum window to drive gain calculation for limiting as provided in the present disclosure is adopted, and the user has set the magnitude level threshold $T$ to 1, the delay duration $t$ to 10 ms, the moving maximum window length $N$ to match the delay duration $t$ (i.e., $N = t = 10$ ms), and the attack time $AT$ to 8 ms in the audio peak limiting system. The audio input signal may be, for example, music, and has been converted through analog-to-digital conversion to have the form of a digital audio input signal.

FIG. 7A illustrates an input signal 710 and an output signal 720 of the moving maximum module. It should be noted that the input to the moving maximum module here refers to the absolute value of the amplitude of the audio input signal, i.e., the input signal 710 is a curve of the magnitude level of the audio input signal represented in unipolar form. The length of the moving maximum window in FIG. 7A is $N = 10$ ms. The output signal 720 is a curve of the moving maximum magnitude level of the input signal 710.

FIG. 7B illustrates an audio input signal 730 before limiting is performed through the audio peak limiting system provided in the present disclosure and an audio output signal 740 after limiting is performed. Both the audio input signal 730 and the audio output signal 740 shown in FIG. 7B have been delayed in time by the delay duration $t = 10$ ms in the main path of the audio peak limiting system. The audio output signal 740 resulting from limiting here may be compared with the aforementioned audio output signal 120 resulting from limiting in FIG. 1A. It can be seen that after limiting by the audio peak limiting system and method provided in the present disclosure, overshoot has been eliminated from the audio output signal 740, and the amplitude of the audio output signal 740 has been completely controlled not to exceed the magnitude level threshold $T = 1$. Comparing FIG. 7A and FIG. 7B, it can be seen that the moving maximum window length $N$ shown in FIG. 7A is configured to match the delay duration $t$ set by the user in FIG. 7B, i.e., for example, $N = t = 10$ ms.

FIG. 7C illustrates a gain curve 750 calculated for and applied to the audio input signal in the audio peak limiting system provided in the present disclosure. Similarly, comparing the gain curve 750 in FIG. 7C with the gain curve 130 shown earlier with reference to FIG. 1B, it can be seen that the gain curve 750 in FIG. 7C, which is calculated and provided using the audio peak limiting system provided in the present disclosure, eliminates the step changes present in the gain curve 130 shown in FIG. 1B, and the gain curve becomes very smooth.

As shown in FIGS. 7A to 7C, if the amplitude of the audio input signal (e.g., 710 in FIG. 7A) is directly used for the gain calculation in the limiter, only the parts exceeding the magnitude level threshold $T$ (e.g., $T = 1$) will trigger gain attenuation. In contrast, in the audio peak limiting system provided in the present disclosure, the moving maximum magnitude level output by the moving maximum module achieves peak holding (refer to 720 in FIG. 7A). Using this moving maximum magnitude level for gain calculation in the audio peak limiting system will trigger gain attenuation for a longer duration. Combining both the holding of the audio amplitude peak within the moving maximum window and the matching of the moving maximum window length $N$ to the delay duration $t$ of the audio input signal in time (making $N = t$, e.g., 10 ms in this example), and setting an attack time $AT$ slightly shorter than the moving maximum window length $N$ (e.g., 8 ms in this example), result in enabling the gain attenuation of the audio peak limiting system to decrease sufficiently before the peak of the audio input signal arrives, as shown in FIG. 7C. Therefore, compared with the gain curve 130 in FIG. 1B described earlier, the gain curve 750 in FIG. 7C, which is calculated and provided using the audio peak limiting system provided in the present disclosure, has no step-like periodic decreases, and the gain curve is very smooth, and there is no overshoot in the audio output signal of the audio peak limiting system. Moreover, the smooth gain curve can also introduce much less limiting distortion.

Examples of one or more implementations of the present disclosure are described in the following clauses:

Clause 1. An audio peak limiting system, comprising:

a time delay module configured to delay an audio input signal in time by a delay duration to obtain a delayed audio input signal;
a moving maximum module configured to determine a moving maximum magnitude level of the audio input signal, wherein the moving maximum magnitude level is a maximum value of a magnitude level of the audio input signal within a moving maximum window, wherein a length of the moving maximum window matches the delay duration;
a static-gain calculation module configured to calculate and output instantaneous gain based on the moving maximum magnitude level of the audio input signal; and
a gain smoothing module configured to smooth the instantaneous gain into smoothed gain; and
a gain application module configured to apply the smoothed gain to the delayed audio input signal to generate an audio output signal.

Clause 2. The system of clause 1, wherein the static-gain calculation module is further configured to:

output the instantaneous gain as 1 when the moving maximum magnitude level of the audio input signal does not exceed a magnitude level threshold; or
output the instantaneous gain as instantaneous-gain attenuation when the moving maximum magnitude level of the audio input signal exceeds the magnitude level threshold.

Clause 3. The system of clause 1 or 2, further comprising a polarity conversion module configured to take an absolute value of an amplitude of the audio input signal to obtain the magnitude level of the audio input signal.
Clause 4. The system of any one of clauses 1 to 3, wherein the gain smoothing module is further configured as a low-pass filter, the low-pass filter configuring coefficients through an attack time and a release time.
Clause 5. The system of any one of clauses 1 to 4, wherein the attack time is set to be less than the delay duration.
Clause 6. The system of any one of clauses 1 to 5, further comprising a loudspeaker displacement model module configured to estimate, based on an amplitude of the audio input signal, a maximum displacement to be generated by a diaphragm of a loudspeaker.
Clause 7. The system of any one of clauses 1 to 6, wherein the magnitude level threshold is set to represent a maximum peak displacement limit of the diaphragm of the loudspeaker.
Clause 8. An audio peak limiting method, comprising the following steps:

delaying, via a time delay module, an audio input signal in time by a delay duration to obtain a delayed audio input signal;
determining, via a moving maximum module, a moving maximum magnitude level of the audio input signal, wherein the moving maximum magnitude level is a maximum value of a magnitude level of the audio input signal within a moving maximum window, wherein a length of the moving maximum window matches the delay duration;
calculating and outputting, via a static-gain calculation module, instantaneous gain based on the moving maximum magnitude level of the audio input signal;
smoothing, via a gain smoothing module, the instantaneous gain into smoothed gain; and
applying, via a gain application module, the smoothed gain to the delayed audio input signal to generate an audio output signal.

Clause 9. The method of clause 8, further comprising: via the static-gain calculation module,

outputting the instantaneous gain as 1 when the moving maximum magnitude level of the audio input signal does not exceed a magnitude level threshold; or
outputting the instantaneous gain as instantaneous-gain attenuation when the moving maximum magnitude level of the audio input signal exceeds the magnitude level threshold.

Clause 10. The method of clause 8 or 9, further comprising: taking, via a polarity conversion module, an absolute value of an amplitude of the audio input signal to obtain the magnitude level of the audio input signal.
Clause 11. The method of any one of clauses 8 to 10, further comprising: configuring a low-pass filter via the gain smoothing module, wherein coefficients of the low-pass filter are configured through an attack time and a release time.
Clause 12. The method of any one of clauses 8 to 11, further comprising: configuring the attack time to be less than the delay duration.
Clause 13. The method of any one of clauses 8 to 12, further comprising: estimating, via a loudspeaker displacement model module, based on an amplitude of the audio input signal, a maximum displacement to be generated by a diaphragm of a loudspeaker.
Clause 14. The method of any one of clauses 8 to 13, further comprising: setting a magnitude level threshold to represent a maximum peak displacement limit of the diaphragm of the loudspeaker.
Clause 15. A non-transitory computer-readable medium having instructions stored thereon, wherein the instructions, when executed by one or more processors, cause the one or more processors to perform the audio peak limiting method of any one of clauses 8 to 14.

The elements of various real-time implementations of the modules, components, and parts for implementing the method provided in the present disclosure may be manufactured as one or more electronic devices residing on the same chip or chipset, including but not limited to arrays of fixed or programmable logic elements (e.g., transistors or gates). One or more elements of the various implementations of the devices described herein may also be implemented, in whole or in part, as one or more instruction sets, which may be arranged to be executed on one or more arrays of fixed or programmable logic elements (e.g., microprocessors, embedded processors, IP cores, digital signal processors, FPGAs, ASSPs, and ASICs, and so on).

The terminology used herein has been chosen to best explain the principles of the embodiments, the practical applications or the improvements to the technology found in the market, or to enable those of ordinary skill in the art to understand the embodiments disclosed herein.

In the foregoing, reference identification have been performed on embodiments presented in the present disclosure. However, the scope of the present disclosure is not limited to the specifically described embodiments. On the contrary, any combination of the above features and elements, whether involving different embodiments or not, is contemplated to implement and practice the contemplated embodiments.

Furthermore, while the embodiments disclosed herein can achieve advantages over other possible solutions or over the prior art, whether or not a specific advantage is achieved by a given embodiment does not limit the scope of the present disclosure. Accordingly, the foregoing aspects, features, embodiments, and advantages are merely illustrative and are not considered to be elements or limitations of the appended claims unless expressly set forth in the claims.

Although the foregoing is directed to embodiments of the present disclosure, other and further embodiments of the present disclosure may be devised without departing from the basic scope of the present disclosure, and the scope of the present disclosure is determined by the appended claims.

## Claims

1. An audio peak limiting system, comprising:

    a time delay module configured to delay an audio input signal in time by a delay duration to obtain a delayed audio input signal;
    a moving maximum module configured to determine a moving maximum magnitude level of the audio input signal, wherein the moving maximum magnitude level is a maximum value of a magnitude level of the audio input signal within a moving maximum window, wherein a length of the moving maximum window matches the delay duration;
    a static-gain calculation module configured to calculate and output instantaneous gain based on the moving maximum magnitude level of the audio input signal;
    a gain smoothing module configured to smooth the instantaneous gain into smoothed gain; and
    a gain application module configured to apply the smoothed gain to the delayed audio input signal to generate an audio output signal.

2. The system of claim 1, wherein the static-gain calculation module is further configured to:

    output the instantaneous gain as 1 when the moving maximum magnitude level of the audio input signal does not exceed a magnitude level threshold; or
    output the instantaneous gain as instantaneous-gain attenuation when the moving maximum magnitude level of the audio input signal exceeds the magnitude level threshold.

3. The system of claim **1,** further comprising a polarity conversion module configured to take an absolute value of an amplitude of the audio input signal to obtain the magnitude level of the audio input signal.

4. The system of claim 1, wherein the gain smoothing module is further configured as a low-pass filter, wherein the low-pass filter is configured to have coefficients related to an attack time and a release time.

5. The system of claim 4, wherein the attack time is set to be less than the delay duration.

6. The system of claim 1, further comprising a loudspeaker displacement model module configured to estimate, based on an amplitude of the audio input signal, a maximum displacement to be generated by a diaphragm of a loudspeaker.

7. The system of claim 6, wherein a magnitude level threshold is set to represent a maximum peak displacement limit of the diaphragm of the loudspeaker.

8. An audio peak limiting method, comprising the following steps:

    delaying, via a time delay module, an audio input signal in time by a delay duration to obtain a delayed audio input signal;
    determining, via a moving maximum module, a moving maximum magnitude level of the audio input signal, wherein the moving maximum magnitude level is a maximum value of a magnitude level of the audio input signal within a moving maximum window, wherein a length of the moving maximum window matches the delay duration; calculating and outputting, via a static-gain calculation module, instantaneous gain based on the moving maximum magnitude level of the audio input signal; smoothing, via a gain smoothing module, the instantaneous gain into smoothed gain; and applying, via a gain application module, the smoothed gain to the delayed audio input signal to generate an audio output signal.

9. The method of claim 8, further comprising: via the static-gain calculation module,

outputting the instantaneous gain as 1 when the moving maximum magnitude level of the audio input signal does not exceed a magnitude level threshold; or outputting the instantaneous gain as instantaneous-gain attenuation when the moving maximum magnitude level of the audio input signal exceeds the magnitude level threshold.

10. The method of claim 8, further comprising: taking, via a polarity conversion module, an absolute value of an amplitude of the audio input signal to obtain the magnitude level of the audio input signal.

11. The method of claim 8, further comprising: configuring a low-pass filter via the gain smoothing module, wherein the low-pass filter is configured to have coefficients related to an attack time and a release time.

12. The method of claim 11, further comprising: configuring the attack time to be less than the delay duration.

13. The method of claim 8, further comprising: estimating, via a loudspeaker displacement model module, based on an amplitude of the audio input signal, a maximum displacement to be generated by a diaphragm of a loudspeaker.

14. The method of claim 13, further comprising: setting a magnitude level threshold to represent a maximum peak displacement limit of the diaphragm of the loudspeaker.

15. A non-transitory computer-readable medium having instructions stored thereon, wherein the instructions, when executed by one or more processors, cause the one or more processors to perform the audio peak limiting method of any one of claims 8-14.

FIG. 1A

FIG. 1B

FIG. 2

FIG. 3

FIG. 4

500

A user may set and adjust a magnitude level threshold T, a delay duration t, an attack time AT, and a release time RT for the audio peak limiting system.　S510

For the audio input signal, an absolute value of the amplitude of the audio input signal is taken via a polarity conversion module to obtain the magnitude level of the audio input signal　S530

The audio input signal is delayed in time by the duration t via a time delay module to obtain a delayed audio input signal　S520

The moving maximum module determines a current magnitude level as a maximum value of the magnitude level of the audio input signal within a moving maximum window　S540

A static-gain calculation module calculates and outputs instantaneous gain according to the current magnitude level, such that the magnitude level of the audio output signal does not exceed the magnitude level threshold T　S550

A low-pass filter configured in a gain smoothing module smoothes the instantaneous-gain attenuation, further eliminating noise introduced into the audio output signal by the instantaneous gain　S560

The smoothed gain is applied to the delayed audio input signal via the gain application module to generate the audio output signal　S570

# FIG. 5

FIG. 6

Moving
maximum
window length
N                    Before and after moving maximum

720

710

## FIG. 7A

Delay
duration t          Digital audio signal

730

740

## FIG. 7B

Attack time AT              Gain

750

## FIG. 7C

Europäisches Patentamt
European Patent Office
Office européen des brevets

# EUROPEAN SEARCH REPORT

**Application Number**

EP 25 22 1456

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 2 070 191 B1 (DOLBY LAB LICENSING CORP [US]) 21 November 2012 (2012-11-21) | 1-3, 8-10,15 | INV. H03G3/30 |
| A | * paragraphs [0040] - [0042], [0074] - [0096]; figures 3a,3b,10,16 * | 4-7, 11-14 | H03G7/00 |
| | ----- | | |
| X | MAKAREWICZ GRZEGORZ ET AL: "Sound Level Control Based on Grey System Theory for Protection Against Hearing Damage Risk in Music Entertainment Venues", 2018 JOINT CONFERENCE - ACOUSTICS IEEE, 11 September 2018 (2018-09-11), pages 1-9, XP033425693, DOI: 10.1109/ACOUSTICS.2018.8502289 [retrieved on 2018-10-22] | 1,2,4,5, 8,9,11, 12,15 | |
| A | * page 4, right-hand column, line 3 - page 5, right-hand column, line 10; figure 8 * | 3,6,7, 10,13,14 | |
| | ----- | | |
| X | HOEG W. ET AL: "DYNAMIC RANGE CONTROL (DRC) AND MUSIC/SPEECH CONTROL (MSC) PROGRAMME-ASSOCIATED DATA SERVICES FOR DAB.", EBU REVIEW- TECHNICAL. EUROPEAN BROADCASTING UNION. BRUSSELS., BE, no. 261., 21 September 1994 (1994-09-21), pages 56-70., XP000486553, ISSN: 0251-0936 | 1,2,4,8, 9,11,15 | |
| A | * page 63, left-hand column, paragraph 5 - page 65, left-hand column, paragraph 1; figures 3a,3b,7 * | 3,5-7, 10,12-14 | |
| | ----- | | |

**TECHNICAL FIELDS SEARCHED (IPC)**

H03G

The present search report has been drawn up for all claims

| Place of search | Date of completion of the search | Examiner |
|---|---|---|
| The Hague | 14 April 2026 | Zakharian, Andre |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 22 1456

This annex lists the patent family members relating to the patent documents cited in the above-mentioned European search report.
The members are as contained in the European Patent Office EDP file on
The European Patent Office is in no way liable for these particulars which are merely given for the purpose of information.

14-04-2026

| Patent document cited in search report | | Publication date | Patent family member(s) | | Publication date |
|---|---|---|---|---|---|
| EP 2070191 | B1 | 21-11-2012 | CN | 101501988 A | 05-08-2009 |
| | | | EP | 2070191 A2 | 17-06-2009 |
| | | | ES | 2399295 T3 | 27-03-2013 |
| | | | JP | 5038417 B2 | 03-10-2012 |
| | | | JP | 2010500613 A | 07-01-2010 |
| | | | TW | 200830704 A | 16-07-2008 |
| | | | US | 2009271185 A1 | 29-10-2009 |
| | | | WO | 2008021110 A2 | 21-02-2008 |

EPO FORM P0459

For more details about this annex : see Official Journal of the European Patent Office, No. 12/82